Europäisches Patentamt

European Patent Office

Office européen des brevets

(11) Publication number: **0 293 260**
**A2**

# EUROPEAN PATENT APPLICATION

(21) Application number: 88304891.0

(22) Date of filing: 27.05.88

(51) Int. Cl.4: **G 01 R 31/28**
**G 06 F 11/26**

(30) Priority: 29.05.87 US 56583

(43) Date of publication of application:
30.11.88 Bulletin 88/48

(84) Designated Contracting States:
AT BE CH DE ES FR GB GR IT LI LU NL SE

(71) Applicant: ZEHNTEL, INC.
2625 Shadelands Drive
Walnut Creek California 94598 (US)

(72) Inventor: McElfresh, Barbara K.
214 Via Mantilla
Walnut Creek California, 94598 (US)

Breniman, Eugene D.
2717 Larkspur Drive
Antioch California, 94509 (US)

(74) Representative: Hustwitt, Philip Edward et al
Hustwitt & Co. St. George's House 44 Hatton Garden
London, EC1N 8ER (GB)

(54) Digital in-circuit tester having a channel-driver inhibitor.

(57) A digital in-circuit tester has a test-head controller which controls driver-receiver channels for driving contact elements of the device under test, and for receiving signals from the contact elements. At least one driver-receiver channel has both a driver and a receiver. The driver includes a data-state-retention means for generating the state to which a corresponding contact element will be driven. The driver also includes a driver-enable-state-retention means for enabling the driver to drive the corresponding contact element. The driver also includes a inhibitor-state-retention means responsive to a driver-enable-nullify instruction from the test-head controller for nullifying the action of the driver-enable-state-retention means, thereby allowing the receiving to receive a signal from the corresponding contact element.

Fig-2

## Description

# A DIGITAL IN-CIRCUIT TESTER HAVING A CHANNEL-DRIVER INHIBITOR

This invention relates to digital in-circuit testers for testing newly-built printed circuit assemblies. Testers usually have a central processing unit, a test-head controller, one or more driver-receiver cards, and channels. The channels are used to either drive a printed circuit assembly test node or receive a signal from that node, or both drive and receive signals. A small in-circuit tester may be equipped with up to about two hundred channels, and can test small boards. Large digital in-circuit testers with more than three thousand channels also exist. Digital in-circuit testers are disclosed in the following patents: U.S. Patent No. 4,339,819 to Jacobsen; U.S. Patent No. 4,216,539 to Raymond et al.; U.S. Patent No. 3,943,439 to Raymond; and U.S. Patent No. 3,931,506 to Borrelli et al. These patents are incorporated herein by reference.

A test-head controller is a complex piece of electronic circuitry which performs many tasks in an in-circuit tester. The test-head controller is often the primary interface between the central processing unit and the rest of the electronic circuits in the tester. In many testers, the test-head controller's list of functions may include control of vacuum valves for fixture actuation, interaction with operator controls and displays, and many other necessary jobs.

An important function of the test-head controller is to control the operation of the driver-receiver cards; that is, assisting them in setting up and executing a burst of test vectors. A "test vector" is a snapshot in time of the state of all the terminals of a device under test ("DUT"). A "burst" is an ordered sequence of vectors intended to conduct a test of the DUT.

Usually the CPU sends information describing a burst to the test-head controller, and then the test-head controller runs the burst.

The test burst produced by the action of the test-head controller is much faster than would be possible were there a small computer organizing the progress of the burst from one vector to the next. Typical computer instruction cycle times are on the order of five hundred to one thousand nanoseconds, and several instructions might be required to get the computer to move from one vector to the next. Thus, the amount of time required to get from one vector to the next in a computer-drive sequence might be more in the neighborhood of five to ten microseconds. A typical test-head controller-based system generates the vectors with special parallel vector-generating hardware capable of delivering a new vector every twenty to five hundred nanoseconds, which is three or more orders of magnitude faster than if a small computer controlled the test vector bursts.

In prior art in-circuit testers, it is common for every terminal of the DUT to be driven and sensed as needed at appropriate occasions during a given test burst.

Commonly in prior-art in-circuit testers, every channel circuit is equipped with a local memory ("RAM"). The memory contains some encoded representation of the sequence of states the channel will go through during the burst. The speed of the memory is often the governing factor in the speed of a test vector burst. If the memory cannot be read but once every one hundred nanoseconds, for example, the driver may not change its state more often than that. Speed is desirable for two reasons. First, devices which pass tests at slow vector burst rates are known to be capable of failing at higher rates. Thus, a faster burst-rate tester is a more effective detector of bad devices. Second, digital in-circuit testers are used in high-production-rate factories, and cannot be allowed to bottleneck vital product flows by consuming time.

Typically, the memories are read out much faster than they are written into. The memories are all read out in parallel during a burst, but the CPU must load them up individually before it can ask the test-head controller to run the burst. Also, prior to the running of the burst, the CPU must execute several instructions for each word of information the CPU transfers to a memory.

Digital in-circuit testers owe their well-known test and diagnostic power to their practice of testing a printed circuit assembly one component at a time. In order to test a single component in a printed circuit assembly, a tester must apply signals directly to its inputs and measure the signals which emanate from its outputs. In particular, and in the idealized case, the tester must pretend that there are no neighboring components generating spurious signals to interfere with the application of the tester's carefully-crafted test vectors. If a neighboring component changes state at an inopportune time, the signal coming from its output may cause noise to superimpose on the signals coming from the tester, and cause an erroneous result.

In-circuit testers attempt to cope with the neighboring-component problem by providing their signals through drivers having very low impedance. Typical in-circuit drivers can drive normal logic voltage levels while sourcing or sinking over four hundred milliamperes. This is called "backdriving" in the test equipment industry. This amount of current is enough to overcome the somewhat higher impedances of the outputs of neighboring components. It is not a complete solution to the problem, however. Some outputs of a printed circuit assembly are actually capable of overcoming a typical in-circuit driver, and other outputs have voluntary signals (e.g. free-running clock oscillators) which cause short-wavelength spikes to leak through the DC backdrive signal.

In any given printed circuit assembly, there is a group of identifiable points which when programmed to the proper state will silence oscillators, and "disable" all data buses. The list is not the same from one printed circuit assembly to another, so it is useful to recognize this property in general and provide for it in the tester's programming system. It is common practice in in-circuit testing to list such points at the beginning of the program in a software construct that will cause the points to be included in every subsequent test burst (programmed to the proper state) whether specifically programmed for that burst or not.

Because the purpose of programming this list of points is to "disable" devices on the DUT which could interfere with the test bursts, the list is commonly referred to as the "disable table". It allows the test programmer to establish a background state in which a DUT is disabled; all subsequent vector bursts in the program will be superimposed on this background state. This saves programming and debugging efforts, by affording the programmer a way to deal with the interference subject just once, and thus not having to acknowledge and work around the problem again on each test of the DUT.

The software system which provides this service of establishing a background state now has an important management job to perform. For each burst, the software must consider whether or not (1) any of the points to be measured are involved in the disable table, and (2) any of the points to be stimulated are involved in the disable table.

The disable table described above is a great convenience, but has a side effect which imposes some overhead on the computer. Consider what happens when the computer's program-execution software comes upon a request of the test program to create a burst to make a measurement to test one output of one component on the DUT. If a given channel to be used to make a measurement happens also to be in the disable table, then that channel's driver would be enabled during the measurement, and the tester would not be able to detect signals produced by the DUT. The enabled DUT channel would suppress the signal the tester needs to measure.

Therefore, before the computer can issue commands to the test-head controller to set up the burst, the computer must look through the disable table to see if any of the channels to be used to make measurements are in the disable table. Every channel which is to be used as a measurement point in a burst needs to be withdrawn from the disable table for the duration of the burst, and then put back into the disable table prior to the next burst.

In effect, the computer software must keep close tabs on the states of the channels at all times, and this "housekeeping" can amount to a considerable amount of overhead. It can affect performance adversely, driving operating cost upward.

Clearly, it would be beneficial to decrease the amount of time spent modifying and returning to normal, the disable table. Also, it would be beneficial to decrease the amount of time spent loading up the channel memories between bursts of test vectors.

Prior art attempts at this include: increasing the speed of the download hardware, e.g. with direct-memory-access (DMA) hardware in the computer; partitioning the channel memory so that one download can serve for many different bursts; improving the efficiency of the code which describes the vectors to be generated, so that long strings of bits can be regenerated from a small amount of downloaded information; and improving the structure of the memory so that operations such as "erase" which affect multiple cells in the memory can be accomplished in a single event.

The present invention implements a new instruction capability in the channel circuit, making it possible for the software to work with reduced overhead relative to management of the channels in the disable table. The present invention simplifies the CPU's job of modifying the disable table and reloading the channel memories with encoded information for the next burst.

The above-noted and other aspects of the present invention will become more apparent from a description of the preferred embodiment when read in conjunction with the accompanying drawings.

The drawings illustrate the preferred embodiment of the invention, wherein like members bear like reference numerals and wherein:

FIG. 1 illustrates a digital in-circuit tester built according to the present invention; and

FIG. 2 depicts part of the driver-receiver channel illustrated in FIG. 1 as part of the digital in-circuit tester.

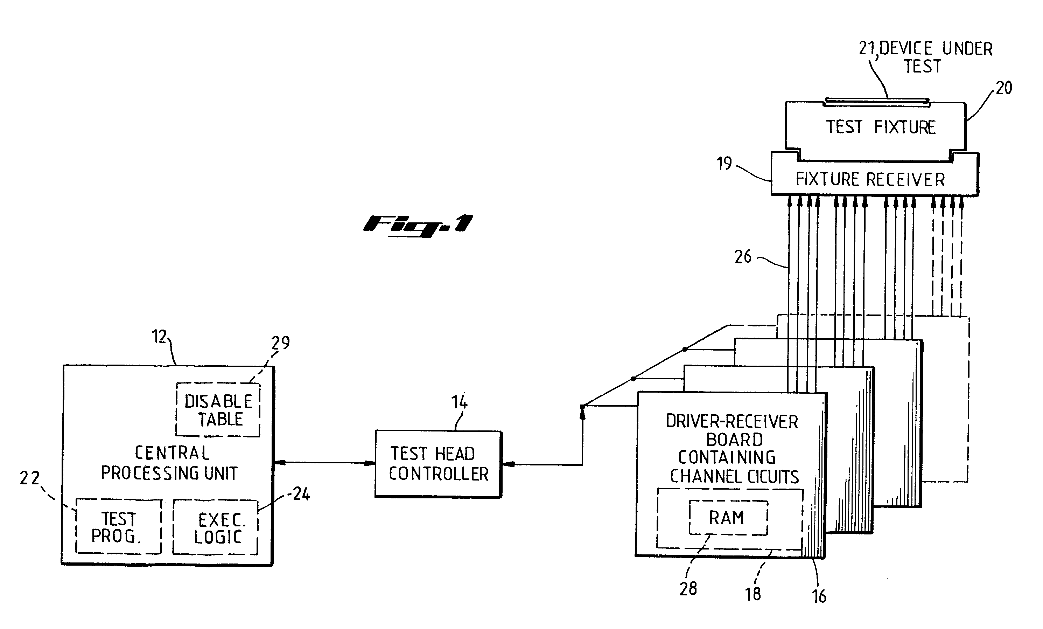

A digital in-circuit tester 10 built according to the present invention is depicted in FIG. 1. The tester 10 contains a central processing unit 12 ("CPU", i.e. a computer), a test-head controller 14, and one or more driver-receiver boards or cards 16 which contain driver-receiver channels, also called channel circuits 18. Some channels 18a only <u>drive</u> a printed circuit assembly being tested with a signal, some channels 18b only <u>receive</u> signals from the printed circuit assembly being tested, while other channels 18c both drive and receive. The test-head controller 14 is concentrated into one module rather than distributed across many driver-receiver boards. This architecture forms an expandable tester. Thus, the test-head controller 14 supports any practical number of driver-receiver channels 18, but in the preferred embodiment supports five-hundred-twelve driver- receiver channels 18, expandable to two thousand forty-eight channels.

The channels 18 are connected to a fixture receiver 19, which is connected to a test fixture 20, which is connected to a device under test 21 ("DUT"). The driver-receiver channels 18 operating in conjunction with the test-head controller 14 generate a burst of test vectors much faster than the central processing unit 12 alone could do it.

The central processing unit 12 stores as software a test program 22, and an execution logic program 24 for the test program 22. Under control of the test program 22 and the execution logic software 24, the central processing unit 12 sends encoded information to the test-head controller 14 describing a burst of test vectors intended to constitute a test or a part of a test of the DUT 20. The test-head controller 14 stores this information in memories located both in the test-head controller 14 and on the driver-receiver boards 16. Upon a subsequent command from the central processing unit 12, the test-head controller 14 causes the channel circuits 18 to generate a test vector burst at high speed according to the encoded information. Thus, there are two main phases in the process: (1) the central processing unit 12 sends information describing a burst to the test-head controller 14; and (2) the test-head controller 14 runs the burst.

At any given point in a burst, the test vector contains information about each connection between the DUT 20 and the tester 10. For every signal line 26 of interest, the tester 10 may be "driving" (i.e. providing a logic signal of low impedance) or receiving. If it is driving, it may be driving a "true" or a "false" level. If the tester is receiving, it will expect to see the DUT deliver a "true" signal or a "false" signal. A driver-receiver channel circuit 18 is capable of representing these four separate logical variables (drive or not, true or false; receive or not, true or false), and thus could be in any one of sixteen states on any given vector in the burst, and could be instructed by the test-head controller 14 either to remain in the same state or to change to any of the other fifteen states for the next vector in the burst.

The channel 18 has a local memory 28 ("RAM"). The central processing unit 12 includes a Disable Table 29.

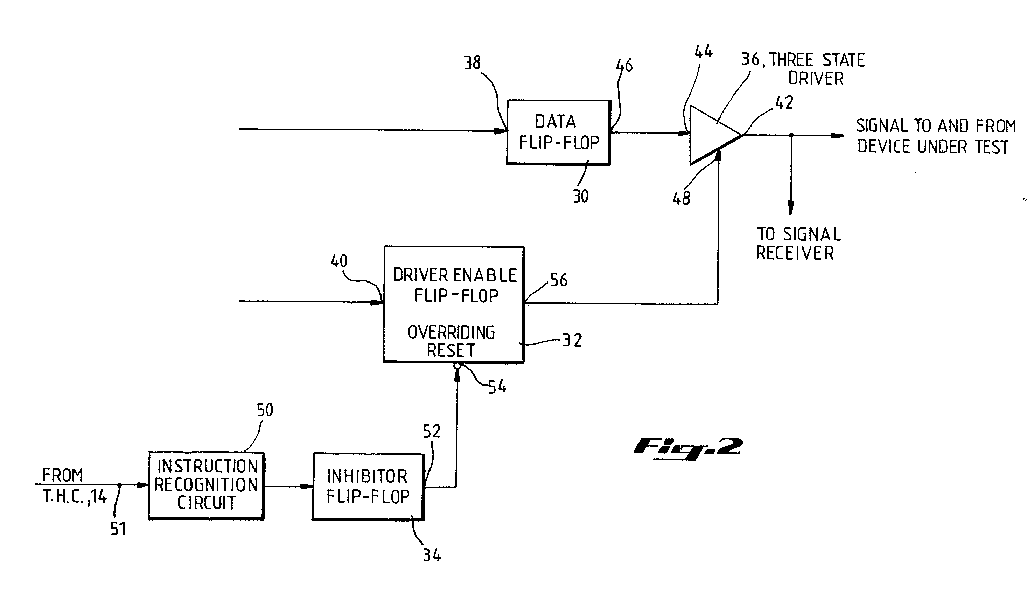

FIG. 2 depicts the driver-receiver channel 18, built according to the present invention. The channel 18 includes a data-state-retention means, that is, a data flip-flop 30; a driver-enable-state-retention means, that is, a driver-enable flip-flop 32; an inhibitor-state-retention means, that is, an inhibitor flip-flop 34; and a three-state driver 36.

The data and driver-enable flip-flops 30, 32 have their inputs 38 and 40, respectively, communicatively coupled to the central processing unit 12, and thus the flip-flops 30, 32 are under the control of the central processing unit 12 which operates cooperatively with the test-head controller 14, and also with other parts of the channel circuit 18.

The three-state driver 36 will force its output 42 "true" when the following two conditions exist: (1) its DATA input 44 connected to the output 46 of the DATA flip-flop 38 is "true"; and (2) its enable input 48 connected to the output 50 of the driver-enable flip-flop 32 is also "true". If the three-state driver's DATA input 44 is "false", and its enable input 48 is "true", then the three-state driver will force its output 42 "false".

If the three-state driver's enable input 48 is "false", the driver 36 will not force its output 42 to go either true or false. Its output 42 will be in what is commonly known as a "high impedance," or "third" state. The driver 36 thus exhibits three operating states, and is accordingly called a three-state driver. The driver 36 may be implemented as an assembly of discrete components or may be a hybrid or a monolithic integrated circuit. In the preferred embodiment, the driver 36 is an assembly of discrete components.

For the tester 10 to be easy to use and effective in testing a variety of DUT's, it is necessary for the channel circuit 18 in the tester 10 both to drive signals into terminals of a DUT and to receive signals from terminals of a DUT. If the driver 36 only possessed two states (i.e. "true" and "false"), it would always be driving, and consequently could never receive. Thus, the third state is needed during reception, when the state of the DUT is to be measured.

Like any other flip-flop, the inhibitor flip-flop 34 is either in a "true" state or a "false" state. Instruction recognition circuitry is well known in the field of digital electronics. An instruction recognition circuit 50 provides a means for the test-head controller 14 to set (and clear) the inhibitor flip-flop 34 with an inhibit instruction 51 from the execution logic software 24 in the central processing unit 12.

An output 52 of the inhibitor flip-flop 34 is connected directly to an overriding reset input 54 on the driver enable flip-flop 32. When the inhibitor flip-flop 34 is set "true" by the instruction recognition circuit 50 the inhibitor flip-flop output 52 forces an output 56 of the driver enable flip-flop 32 to be always false. It should be understood that this is only one of many possible ways in which the invention could be implemented. There are several other ways in which the inhibitor flip-flop 34 could be made to suppress or nullify the action of the driver enable flip-flop 32: (1) a gate in the clock or data inputs to the driver enable flip-flop 32; (2) a gate preventing the output 56 of the driver enable flip-flop from reaching the enable input 48 of the three-state driver 36; a secondary enabling input in the three-state driver 36; etc.

The present invention thus allows simplified software to operate the tester 10. When the test program execution logic software 24 executes a request for a burst with some channels measuring, it is not necessary for the execution logic software 24 to search or modify the disable table 29, and reestablish the disable table 29 afterwards, as in prior art testers. Rather, the execution logic software 24 simply instructs the test-head controller 14 to send the inhibit instruction 51 to every channel 18 which will be measuring, that is, used as a receiver, during the burst.

The execution logic software 24 then sets up the rest of the burst parameters and commands the test-head controller 14 to run the burst. After the conclusion of the burst, the execution logic software "reasserts" the disable table 29 simply by instructing the test-head controller 14 to reset all of the inhibit flip-flops 34. It is not necessary for the execution logic software 24 to ask the test-head controller 14 to reprogram the channel memories 28 for the disable table 29.

Thus, considerable savings are obtained both in searching and modifying data structures in memory and in central processing unit cycles expended in transferring instructions to and from the test-head controller.

The principles, preferred embodiments and modes of operation of the present invention have been described in the foregoing specification. The invention is not to be construed as limited to the particular forms disclosed, since these are regarded as illustrative rather than restrictive. Moreover, variations and changes may be made by those skilled in the art without departing from the spirit of the invention.

## Claims

1. In a digital in-circuit tester having a test-head controller which controls driver-receiver channels for driving contact elements of a device under test, and for receiving signals from the contact elements, at least one driver-receiver channel having a driver and a receiver, the driver comprising:

a) a data-state-retention means communicatively coupled to the test-head controller, responsive to a contact-element-state instruction, for generating the state to which a corresponding contact element will be driven;

b) a driver-enable-state-retention means communicatively coupled to the test-head controller, responsive to a driver-enable instruction from the test-head controller for enabling the driver to drive the corresponding contact element; and

c) an inhibitor-state-retention means communicatively coupled to the test-head controller, responsive to a driver-enable-nullify instruction from the test-head controller for nullifying the action of the driver-enable-state-retention means, thereby allowing the receiver to receive a signal from the corresponding contact element.

2. In a digital in-circuit tester having a test-head controller which controls a plurality of driver-receiver channels for driving contact elements of a device under test, and for receiving signals from the contact elements, at least one driver-receiver channel having a driver and a receiver, the driver comprising:

a) a first flip-flop communicatively coupled to the test-head controller, responsive to a contact-element-state instruction, for generating the state to which a corresponding contact element will be driven;

b) a second flip-flop communicatively coupled to the test-head controller, responsive to a driver enable instruction from the test-head controller for enabling the driver to drive the corresponding contact element; and

c) a third flip-flop communicatively coupled to the test-head controller, responsive to a driver-enable-nullify instruction from the test-head controller for nullifying the action of the second flip-flop, thereby allowing the receiver to receive a signal from the corresponding contact element.

3. In a digital in-circuit tester having a test-head controller which controls driver-receiver channels for driving their corresponding contact elements of a device under test, and for receiving signals from the contact-elements, the digital in-circuit tester having at least one driver-receiver channel having a driver and a receiver, a method of inhibiting a given driver in a given driver-receiver channel to allow a corresponding given receiver in the given driver-receiver channel to receive a signal from a contact element corresponding to the given driver-receiver channel, the method comprising the steps of:

a) inhibiting the given driver;

b) generating a state to which a plurality of contact elements will be driven;

c) enabling the drivers to drive their corresponding contact elements; and

d) receiving the signal from the contact element corresponding to the given driver-receiver channel.

4. In a digital in-circuit tester having a test-head controller which controls driver-receiver channels for driving their corresponding contact elements of a device under test, and for receiving signals from the contact-elements, the digital in-circuit tester having at least one driver-receiver channel having a driver and a receiver, a method of inhibiting a given driver in a given driver-receiver channel to allow a corresponding given receiver in the given driver-receiver channel to receive a signal from a contact element corresponding to the given driver-receiver channel, the method comprising the steps of:

a) inhibiting the given driver;

b) enabling the drivers to drive their corresponding contact elements;

c) generating a state to which a plurality of contact elements will be driven; and

d) receiving the signal from the contact element corresponding to the given driver-receiver channel.

Fig.1

21,DEVICE UNDER
TEST

20

TEST FIXTURE

19

FIXTURE RECEIVER

26

12

29

DISABLE
TABLE

14

CENTRAL
PROCESSING UNIT

TEST HEAD
CONTROLLER

DRIVER-RECEIVER
BOARD
CONTAINING
CHANNEL CICUITS

22

TEST
PROG.

24

EXEC.
LOGIC

RAM

28

18

16

0293260

Fig.2

DATA FLIP-FLOP 38 46

36, THREE STATE DRIVER 44 42

30

48

SIGNAL TO AND FROM DEVICE UNDER TEST

TO SIGNAL RECEIVER

DRIVER ENABLE FLIP-FLOP 40 56

OVERRIDING RESET 32

54

INSTRUCTION RECOGNITION CIRCUIT 50

INHIBITOR FLIP-FLOP 52

34

FROM T.H.C.,14 51